(19) Europäisches Patentamt
European Patent Office
Office européen des brevets

(11) **EP 4 542 620 A1**

(12) **EUROPEAN PATENT APPLICATION**

(43) Date of publication:
**23.04.2025 Bulletin 2025/17**

(21) Application number: **23203957.8**

(22) Date of filing: **17.10.2023**

(51) International Patent Classification (IPC):
*H01J 37/32* (2006.01)  *H03H 7/40* (2006.01)

(52) Cooperative Patent Classification (CPC):
**H01J 37/32183; H01J 37/32926; H03H 7/40;**
H03H 2210/025

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Comet AG
3175 Flamatt (CH)**

(72) Inventors:
• **Grede, André
3018 Bern (CH)**
• **Fink, Thomas
5603 Staufen (CH)**
• **Abrecht, Mike
3174 Thörishaus (CH)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

Remarks:
Amended claims in accordance with Rule 137(2)
EPC.

(54) **METHOD FOR OPERATING AN ELECTRONIC SYSTEM AND ELECTRONIC SYSTEM**

(57) Method for operating an electronic system comprising a radio frequency, RF, matching network, wherein the RF matching network comprises a plurality of electronic components, wherein at least one of the electronic components is a variable reactance component, wherein the method includes: monitoring activity information of the at least one variable reactance component; and determining a predicted lifetime from the activity information.

Fig. 4

## Description

The present invention relates to a method for operating an electronic system comprising a radio frequency (RF) matching network. In particular, the present invention relates to a method for operating an electronic system of a plasma application. Further, the present invention relates to an electronic system comprising an RF matching network, an RF generator, a plasma system and a storage medium.

## Background

Plasma applications usually contain a plasma chamber in which a plasma is generated for surface processing and treatment such as plasma etching or plasma deposition. For example, the production of modern semiconductor chips, flat panel displays and photovoltaic panels relies heavily on plasma etching and plasma deposition. In order to generate the plasma in the plasma chamber, a gas is partially ionized by applying electric power, which can be DC or AC, but for many applications that power is preferably supplied as radio frequency power. To this effect, the plasma chamber is connected to an electronic system. The electronic system comprises a high-power RF generator providing an RF signal with a frequency preferably between 0.3 MHz and 300 MHz and with a power preferably between 0.05 kW and 50 kW. Advanced plasma etching and deposition processes may require the RF power to be pulsed with various pulse levels and with repetitive pulse schemes which can be characterized by their duty cycles and power levels.

Due to the variable impedance of the plasma in the plasma chamber, a RF matching network is provided between the RF generator and the plasma chamber in order to match the output impedance of the electronic system to the impedance of the plasma which constitutes a dynamic, time-varying load for the electronic system. Thereby, the RF matching network is a crucial component in the electronic system and prevents excessive reflected power from the plasma system back to the RF generator due to impedance mismatch and thereby protects the electronic components of the RF generator such as the power amplifiers.

In order to match the impedance of the electronic system, the RF matching network usually comprises one or more variable reactance components, which are mechanically driven in order to change the reactance, thus the impedance. Due to the mechanical movement of the variable reactance components of the RF matching network, these components suffer from a limited lifetime. Failure of the variable reactance components may render the electronic system and consequently the whole plasma system inoperable. In addition, sudden failure of the variable reactance components during operation may have severe impact on the electronic components of the RF generator and may lead to destruction or at least damage of the RF generator.

In the context of this invention, the term maintenance or service is to be understood as any activity which is performed to ensure the proper functioning of the electronic system in its intended use, e. g. in a production facility.

Unscheduled maintenance is performed after an unexpected failure of the electronic system and often includes repair or replacement of malfunctioning components.

Preventive maintenance is scheduled regularly after a specific interval of time or after a specific number of usage cycles of the electronic system. Preventive maintenance may include calibration of precision components or planned replacement of components prior to their end of usable life, thus making sure that the component does not fail due to normal wear while the electronic system is used for production purposes.

In a production environment, unscheduled downtime of equipment due to failures and any unscheduled maintenance has to be minimized. Typically, unscheduled maintenance can be avoided by defining appropriate service or maintenance intervals for re-calibration and by replacing preventively components, in particular mechanical components, which are near their expected end of life.

Hence, the mechanical components, such as the variable reactance components of the RF matching network, need to undergo regular preventive maintenance and need to be replaced prior to any adverse effects on the electronic system. However, this may lead to unnecessary costs due to service intervals which are precautionary selected to be too small.

For example, for plasma systems, even technically identical systems may cause totally different wear out on the components of the electronic system because of different recipes being used in process cycles. Influenced by process parameters like plasma impedance, RF power level, gas pressure, gas flow, process gases and process gas mix, recipe preset conditions of the electronic system etc., more or less RF power is dissipated within the RF matching network causing lower or higher component temperatures. In particular, the adjustable reactance components may experience more or less stressful conditions.

US20220334197A1 describes an electrical system comprising a matching network with variable capacitors, a controller, and a life-consumed module. Based on telemetry data of the capacitors in operation, together with environmental data, the life-consumed module reports an indication of life consumed for at least one of the capacitors. In this publication, apart from the telemetry data, only environmental data, e. g. the ambient temperature, are used for determining the consumed life. However, other parameters, in particular, the actual temperatures of individual components of the capacitors, which have a major influence on lifetime, are not taken into consideration. Moreover, although the consumed life of a capacitor may be determined with this approach, it is not described in this publication how the remaining usable time of the capacitor, which depends on its further usage, is determined. In consequence, it is not possible to plan preventive maintenance or replacement of the capacitors.

Thus, it is an objective of the present invention to provide a method for operating an electronic system more predictably by using a more precise method to determine the remaining lifetime of components.

Summary

The problem is solved by a method according to claim 1, an electronic system according to claim 15, a plasma system according to claim 16 and a non-transitory storage medium according to claim 17.

In a first aspect, a method for operating an electronic system is provided. The electronic system comprises a radio frequency (RF) matching network in order to match an impedance of the output of the electronic system to a load such as a plasma chamber having a variable impedance. In particular, the electronic system may comprise further an RF generator in order to provide a high-power RF signal having a frequency preferably between 0.3 MHz and 300 MHz and a power preferably between 0.05 kW up to 50 kW. The RF matching network comprises a plurality of electronic components, wherein at least one of the electronic components is a variable reactance component. Therein, the variable reactance component provides a mechanically adjustable impedance, such that by mechanical adjustment of the variable reactance components the impedance at the output of the electronic system can be adapted. The method includes:

- monitoring activity information of the at least one variable reactance component and
- determining a predicted lifetime from the activity information.

Thus, according to the present invention, the activity information of the at least one variable reactance component is monitored and detected. In dependence on the actual movement of the at least one variable reactance component, a predicted lifetime is determined which is used to assess the necessity of whether recalibration, repair or replacement is needed. Hence, preventive maintenance can be performed in accordance with the actual usage of the variable reactance component. For example, if the RF matching network is connected to a volatile load and high number of adjustments of the impedance are necessary within short time, lifetime of the variable reactance component might be consumed in shorter time than compared to a more constant load or reduced usage of the overall electronic system. Hence, service intervals can be specifically tailored to the need and use of the electronic system without the risk of failure by unintentionally exceeding the lifetime of the at least one variable reactance component.

Preferably, the method further includes:

- monitoring at least one operation parameter of the electronic system wherein operation parameters can include one or more of the following: current, RF power level, RF frequency, pulsing information and duty cycle;
- determining from the at least one operation parameter a temperature of the electronic system; and
- determining a predicted lifetime from the activity information and the determined temperature.

Thus, the predicted lifetime is determined from a combination of the monitored activity information and the determined temperature. Therein, the temperature is not or may not be directly measured. Instead, at least one operation parameter of the electronic system is monitored, and the temperature of the electronic system or a component of the electronic system is determined from this at least one operation parameter. Since temperature has a tremendous influence on the lifetime of the electronic components and the variable reactance component, detailed knowledge about the temperature of the electronic system increases the accuracy of the predicted lifetime. Therein, the temperature at different components or locations within the electronic system may have a different influence on lifetime. Instead of measuring the temperature at a plurality of locations within the electronic system, the temperature can be determined directly from the at least one operation parameter, which is already known when operating the electronic system. Thus, complexity of the hardware of the electronic system can be kept simple and, at the same time, detailed knowledge about the temperature and the electronic system can be acquired by the at least one operation parameter.

Preferably, the method further includes:

- monitoring an RF frequency of operation of the electronic system; and
- determining a predicted lifetime from the activity information, and the RF frequency of operation and preferably the determined temperature.

Thus, the predicted lifetime is determined from the activity information and the RF frequency of operation generated by the electronic system. In particular, if the temperature is determined as described before, the predicted lifetime is determined from a combination of the activity information and the RF frequency of operation together with the determined temperature. Since the RF frequency at which the electronic system is operating has an influence on the lifetime of the variable reactance component, accuracy of the predicted lifetime is increased by considering also the RF frequency of operation.

Preferably, if a remaining predicted lifetime is below a predetermined threshold, a warning signal is generated. Therein, the warning signal can be a visual signal such as a warning lamp, an audio signal or message displayed by the electronic system or provided to a user interface of the electronic system or a control unit of the electronic system. Alternatively or additionally, the warning signal can be a digital status signal transmitted to a remote server or device. Thus, if a warning signal is generated, the user or manufacturer of the electronic system can plan and perform a service in time and plan such maintenance ahead prior to failure.

Preferably, the predicted lifetime is displayed and/or transmitted to a remote server. Hence, continued monitoring of the electronic system and in particular the predicted lifetime is possible, either directly at the electronic system, for example at a control unit, or a user interface of the control unit, or the predicted lifetime can be displayed, controlled and further processed at a remote server. In particular, the remote server may receive the predicted lifetime of a plurality of different electronic systems and their RF matching networks.

Preferably, the variable reactance component is one of a mechanically adjustable gas capacitor, a mechanically adjustable vacuum capacitor, and a mechanically adjustable inductor. Therein, the mechanically adjustable inductor may comprise a coil with a ferrite, wherein the coil has a sliding tap contact to adapt the number of windings of the inductor. Alternatively, the relative position between the coil and the ferrite may be mechanically adjusted. The mechanically adjustable gas or vacuum capacitor comprises two electrodes which are either in a gas or vacuum, wherein the gas or vacuum serves as dielectric material. At least one of the electrodes is movable such that the distance or the overlap area between the two electrodes in the gas capacitor or vacuum capacitor can be adjusted to adjust the capacitance.

Preferably, the activity information is a mechanical adjustment of the variable reactance component. In particular, the activity information is the cumulative movement distances, which can be expressed by $\Sigma_i |x_i|$, wherein $x_i$ denotes the movement distance from a first position to a second position.

Preferably, the at least one operation parameter comprises an electric current of the electronic system and, in particular, in at least one of the plurality of electronic components. In particular, the electric current may be the electric current at the output of the impedance matching network, the current at the variable reactance component, or the current detected by a sensing circuit such as a VI voltage-current sensor. In particular, the operation parameter can be the integrated parameter of a time; for the example of the current $I(t)$, the considered operation parameter may by $\int_0^{t_0} I(t)\, dt$ with $t_0$ as the current time, or the cumulative duration of the current in a specific range or above a certain threshold.

Preferably, determining a temperature of the electronic system from the at least one operation parameter includes at least one or more of:

- pre-determine a look-up table providing a connection/relation between the at least one operation parameter and the temperature, and, during operation, look up the temperature for the respective operation parameter in the look-up table;
- pre-determine a model of one of the variable reactance component and/or any other electronic component providing a functional relationship between the at least one operation parameter and the temperature, and use the functional relationship during operation to determine the temperature;
- pre-determine a model of the electronic system comprising the at least one variable reactance, further components, and parasitic inductances, capacitances and resistances, providing a functional relationship between the values of the variable reactances and the at least one operation parameter and the temperature, and use the functional relationship during operation to determine the temperature; and
- train a machine learning algorithm to determine the temperature from the at least one operation parameter, and use the trained machine learning algorithm during operation to determine the temperature.

Preferably, the temperature comprises one or more of the temperature of the variable reactance component, the temperature of any other electronic component of the RF matching network, and the air temperature within the electronic system. Therein, at least one of these temperatures might be determined as temperature from the at least one operation parameter or a combination of these temperatures is determined from the at least one operation parameter. In particular, the respective temperatures can be determined as described before either by a look-up table, a model providing a functional relationship or a machine learning algorithm correlating the at least one or more operation parameter with one of these temperatures.

Preferably, the predicted lifetime includes a predicted number of remaining process cycles, wherein the predicted lifetime is calculated by the predicted number of remaining process cycles and a time between two subsequent process cycles. In particular, the predicted lifetime is calculated by multiplying the predicted number of remaining process cycles and the time between two subsequent process cycles. Alternatively, the predicted lifetime is determined by multiplying the predicted number of remaining process cycles and an average time between two subsequent process cycles.

Preferably, if the electronic system is operated in two or more different process cycles, the predicted lifetime is determined by a combination of the predicted numbers of remaining process cycles for each different process cycle and the frequency of occurrence of each of the different process cycles. Hence, if for example two different cycles are implemented, the lifetime is determined by the predicted number of remaining process cycles for the first process and the time of occurrence of the first process cycle and the predicted number of remaining process cycles for the second process cycle and the times of occurrence for the second process cycle.

Preferably, the process cycles and the time between two process cycles is determined by a pattern recognition. In particular, in repeating process steps of a process cycle, positions of the at least one variable reactance component might be equal or at least similar. Therein, upon detection of a pattern of the position of the variable reactance component repeating characteristics in the position of the variable reactance component can be detected by the pattern recognition identifying the time between two subsequent process cycles.

Preferably, determining the predicted lifetime includes at least one or more of:

- pre-determine a look-up table providing a connection/relation of the activity information and preferably the temperature and/or the RF frequency with the predicted lifetime, and, during operation, look up the predicted lifetime for the respective activity information and preferably the temperature and/or the RF frequency in the look-up table;
- pre-determine a functional relationship between the activity information preferably with the temperature and/or the RF frequency and the predicted lifetime, and use the functional relationship during operation to determine the predicted lifetime; and
- train a machine learning algorithm to determine the predicted lifetime from the activity information preferably with the temperature and/or the RF frequency, and use the trained machine learning algorithm during operation to determine the predicted lifetime.

In another aspect, the present invention relates to an electronic system comprising an RF matching network, wherein the RF matching network comprises a plurality of electronic components, wherein at least one of the electronic components is a variable reactance component. Further, the electronic system comprises a control unit, wherein the control unit which may comprise a processor is configured to perform the steps of the method described before.

Preferably, the electronic system comprises an RF generator in order to generate an RF high power signal to be provided to a load. Therein, the load might be a plasma chamber for surface processing and treatment.

In another aspect, the present invention relates to a plasma system comprising an electronic system as described before and a plasma chamber connected to the electronic system to generate a plasma.

In another aspect of the present invention, a non-transitory, tangible processor readable storage medium encoded with processor readable instruction is provided wherein, when these instructions are executed by a processor, the control unit performs the steps of the method described before.

<u>Description of the drawings</u>

In the following the present invention is described in more detail with reference to the accompanying figures.

The figures show:

Figure 1 a schematic representation of a plasma system according to the present invention,

Figure 2 a flow diagram of the method according to the present invention,

Figure 3 a flow diagram of the method according to the present invention,

Figure 4 a schematic representation of the embodiment according to the present invention,

Figures 5A and 5B an exemplary representation of the activity information,

Figure 6 a representation of the predicted lifetime according to the present invention and

Figure 7 a schematic representation of process cycles of the plasma system according to the present invention.

Figure 8A an example of a single plasma process for which the matching network starts from capacitor preset positions which require a large travel to reach the tuned position

Figure 8B an example of a repeated plasma process for which the matching network uses capacitor preset positions which require a large travel to reach the tuned position

Figure 9A a second example of a single plasma process for which the matching network starts from capacitor preset positions which require a large travel to reach the tuned position

Figure 9B a second example of a repeated plasma process for which the matching network uses capacitor preset positions which require a large travel to reach the tuned position

Figure 10A an example of a single plasma process for which the matching network starts from improved capacitor positions with less travel to reach the tuned position

Figure 10B an example of a repeated plasma process for which the matching network starts from improved capacitor positions with less travel to reach the tuned position

Figure 11A an example of a single plasma process for which the matching network starts from optimized capacitor positions with minimum travel to reach the tuned position

Figure 11B an example of a repeated plasma process for which the matching network starts from optimized capacitor positions with minimum travel to reach the tuned position

Figure 12 a typical relationship between the extent of capacitor movement (in percent of its nominal range) and the average number of capacitor or tuning cycles until failure of the bellows (from Comet Plasma Control Technologies Service Bulletin SB-56)

Detailed Description

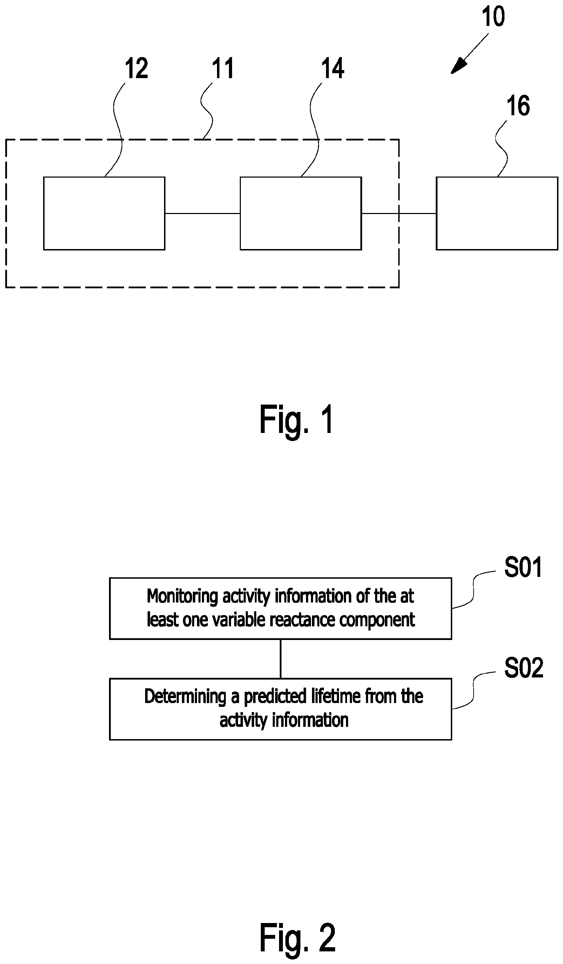

Referring to Figure 1, the plasma system 10 according to the present invention comprises an electronic system 11, which is connected to a plasma chamber 16 in order to generate a plasma in the plasma chamber 16 for surface processing and treatment, in particular for semiconductors. Therein, the electronic system 11 comprises a high-power RF generator 12 providing a high power RF signal in particular with a frequency between 0.3 MHz and 300 MHz and a power of between 0.05 kW and 50 kW. In order to match the output impedance of the electronic system 11 with the variable impedance of the plasma in the plasma chamber 16, an RF matching network 14 is connected in-between the RF generator 12 and the plasma chamber 16. By the RF matching network 14, the impedance of the electronic system 11 is matched to the impedance of the plasma in the plasma chamber 16. Therefore, the RF matching network 14 comprises at least one variable reactance component. The variable reactance component might be one of a mechanically adjustable gas capacitor, a mechanically adjustable vacuum capacitor, and a mechanically adjustable inductor. The mechanically adjustable gas capacitor and the mechanically adjustable vacuum capacitor comprise two electrodes which are moveable such that the distance or the overlap area between the electrodes is variable in order to adjust the capacitance of the mechanically adjustable gas capacitor and the mechanically adjustable vacuum capacitor. Therein, a gas is used as dielectric material in the mechanically adjustable gas capacitor, and in the mechanically adjustable vacuum capacitor, vacuum is used as a dielectric material. Therein, the mechanically adjustable inductor may comprise a coil with a ferrite, wherein the coil has a sliding tap contact to adapt the number of windings of the inductor. Alternatively, the relative position between the coil and the ferrite may be mechanically adjusted. Hence by mechanical adjustment of the variable reactance component, the impedance of the electronic system 11 can be adjusted and matched to the impedance of the plasma in the plasma chamber 16.

In the following it is referred to Figure 2 showing the method for operating the electronic system 11.

In step S01, activity information of the at least one variable reactance component is monitored.

In step S02, a predicted lifetime for the at least one variable reactance component is determined from the activity information.

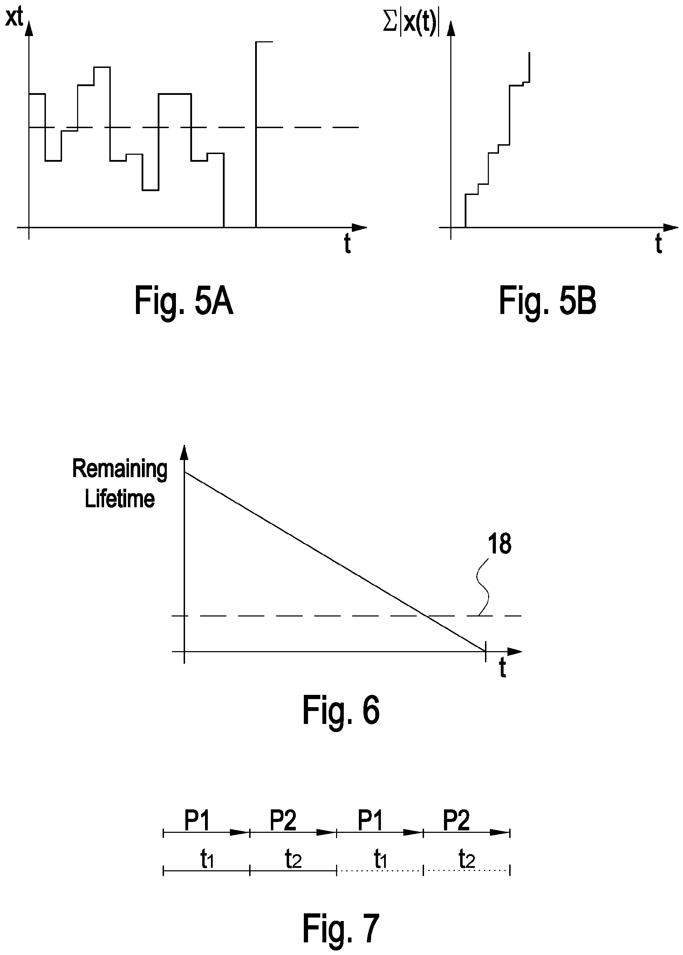

Thus, the activity information of the at least one variable reactance component is monitored and used in order to predict a lifetime from the activity information. Therein, as noted above, the activity information may be the movement of one of the electrodes of the mechanically adjustable gas capacitor or mechanically adjustable vacuum capacitor, may be the movement of the ferrite relative to the coil in the mechanically adjustable inductor, or may be the position of the tapped contact of the coil in the mechanically adjustable inductor. Therein, the predicted remaining lifetime is exemplified in Figure 6, wherein a threshold 18 is denoted in Figure 6. If the predicted lifetime falls below the predetermined threshold 18, a warning signal may be generated. Therein, the warning signal can be a visual signal such as a warning lamp, an audio signal or message displayed by the electronic system or provided to a user interface of the electronic system or a control unit of the electronic system. Alternatively or additionally, the warning signal can be a digital status signal transmitted to a remote server or device. Thus, if a warning signal is generated, the user of the electronic system or manufacturer of the semiconductor being processed by the electronic system can plan and perform a maintenance in time and plan such maintenance ahead prior to failure.

In addition, the predicted lifetime may be displayed and/or transmitted to a remote server. Hence, continued monitoring of the electronic system and in particular the predicted lifetime is possible, either directly at the electronic system, for example at a control unit, or a user interface of the control unit or the predicted lifetime can be displayed, controlled and further processed at a remote server. In particular, the remote server may receive the predicted lifetime of a plurality of different electronic systems and their RF matching networks.

Preferably, the steps S01 and S02 of Figure 2 are repeated continuously or in preset time intervals, for example every hour, every 10 minutes, every 1 minute, every 30 sec., every 5 sec., in order to continuously determine the predicted lifetime on the basis of the actual operation condition of the electronic system.

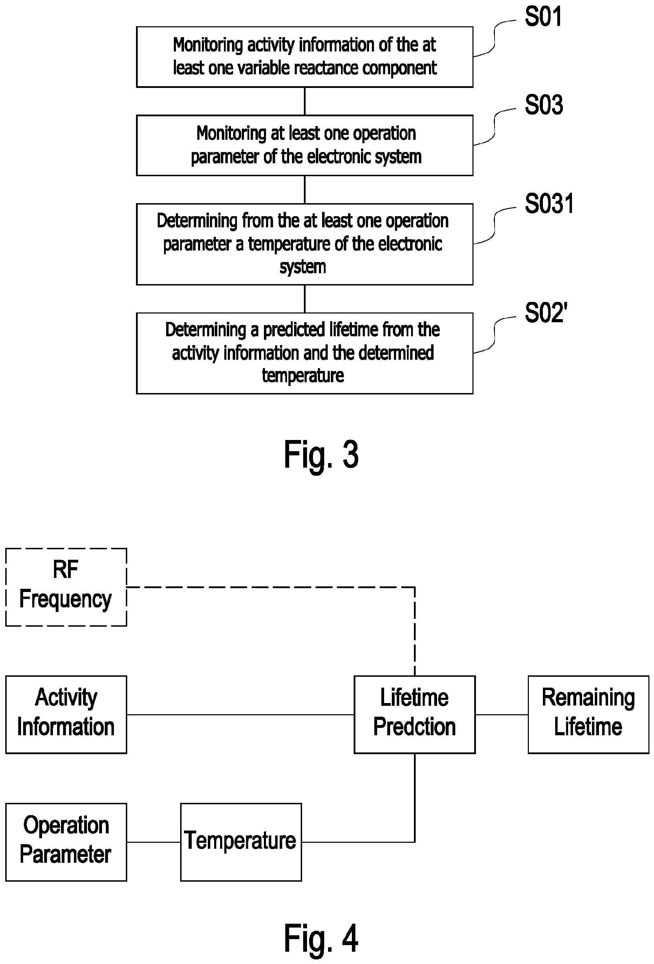

It is now referred to Figure 3 showing a flow diagram of the method according to the present invention. In addition to the method as shown in Figure 2 in step S03 at least one operation parameter of the electronic system is monitored. Therein, the at least one operation parameter might be one or more of an electric current of the electronic system and, in particular, in at least one of the plurality of electronic components. In particular, the electric current may be the electric current at the output of the impedance matching network, the current at the variable reactance component or the current detected by a sensing circuit such as a VI voltage-current sensor. In particular, the operation parameter can be the integrated parameter over time. For the example of the current $I(t)$, the considered operation parameter may be

$$\int_0^{t_0} I(t) \, dt$$

with $t_0$ as the current time, or the cumulative duration of the current within a specific range or above a certain threshold.

In step S031, from the at least one operation parameter, a temperature of the electronic system is determined. Thus, in accordance with the present invention the already known operation parameter is used to determine the temperature of the electronic system. Therein, the temperature of the electronic system may encompass a temperature of the variable reactance component, a temperature of any other electronic component, or the air temperature within the electronic system. One of these temperatures, more than one or all of these temperatures have an influence on the predicted lifetime and considering them increases the accuracy of the predicted lifetime. Hence, in step S02' the predicted lifetime is determined combinedly from the activity information and the determined temperature.

Referring to Figure 4 showing a diagram of the method according to the present invention. In the example of Figure 4, the activity information, the operation parameter and the RF frequency are depicted. However, it should be understood that prediction of a lifetime may be alternatively based on the activity information, may be based on a combination of activity information and operation parameter, or may be based on activity information and RF frequency. From the operation parameter, possibly under consideration of the RF frequency, the temperature is determined. Therein, temperature determination can be performed either by a predetermined look-up table providing a correspondence between the respective operation parameter and the temperature such that during operation the temperature can be looked up for the respective operation parameter. The look-up table may be different for different RF frequencies. Alternatively, a predetermined model of the variable reactance component and/or any other electronic component is provided establishing a functional relationship between the at least one operation parameter and the temperature, wherein during operation, the functional relationship is used in order to determine the temperature. In particular, the model can be based on material properties and geometries of all sub-components of the electronic system, including heat exchange capabilities with the surrounding structure of the sub-components and in particular of those of the variable reactance component. The mechanical design of the variable reactance component could be an FEM model calculated once in order to obtain the functional relationship between the at least one operation parameter and the temperature. Alternatively, a machine learning algorithm is trained in order to determine a corresponding relationship between the temperature and the at least one operation parameter. The trained machine learning algorithm is used to determine the temperature from the current operation parameter.

The activity information is exemplified in Figures 5A and 5B. Therein, Figure 5A shows the position of the variable reactance component at different times t, wherein during operation the position of, for example, the electrodes of the variable reactance component is depicted. Figure 5B shows a cumulated activity information providing the cumulative distance of movement of the variable reactance component such as for example the electrodes of the variable reactance component.

Referring back to Figure 4, for the lifetime prediction the activity information, the temperature and, in the example of figure 4 as an optional information, also the RF frequency is considered (indicated by dashed lines). Therein, the predicted lifetime is determined according to a predetermined look-up table providing a connection of the activity information and the predicted lifetime, wherein during operation, the predicted lifetime is looked up in the predetermined look-up table for the respective activity information. If more information such as temperature and RF frequency is considered as in the example of Figure 4, the look-up table may provide a connection between the activity information, the temperature and the RF frequency in order to be able to look-up the predicted lifetime for the respective activity information, temperature and RF frequency.

Alternatively, a functional relationship between the activity information and the predicted lifetime is provided. This functional relationship may be a fitted function to experimental data or may be a pre-calculated functional relationship on the basis of historical data for measured lifetimes of the variable reactance components during lifetime testing. During operation, the functional relationship is used to determine the predicted lifetime from the activity information. As in the example of Figure 4, additional information such as the temperature and the RF frequency, only the temperature, or only the RF frequency are also considered in the functional relationship in order to increase the accuracy of the predicted lifetime.

Alternatively, a machine learning algorithm is trained to determine the predicted lifetime from the activity information, wherein during operation the trained machine learning algorithm is used in order to determine the predicted lifetime. The machine learning algorithm may be trained on the basis of historical lifetime data of variable reactance components, historical data of operation of electronic systems of the same kind or the like. As in the example of Figure 4, additional information such as the temperature and the RF frequency, only the temperature or only the RF frequency are also considered in the machine learning algorithm in order to increase the accuracy of the predicted lifetime.

With the predicted lifetime, a remaining lifetime may be calculated on the basis of a predicted number of remaining process cycles, and the time or average time between subsequent process cycles. Therein, the process cycles can be identified by pattern recognition on the basis of the monitored activity information. Due to similarity of the process from one cycle to another for the same process, also the activity information is identical or at least similar for subsequent process cycles. Therein, the remaining lifetime can be calculated for example by multiplying the predicted number of remaining process cycles and the average time period in between two subsequent process cycles.

Referring now to Figure 7, if different processes are carried out by the plasma system, according to the present invention, for each process P1, P2, a predicted number of remaining process cycles is determined. The remaining lifetime is then calculated on the basis of the respective number of occurrences of the processes P1 and P2 and the respective times in between as exemplified in Fig. 7.

Hence, according to the present invention a reliable method for determining the remaining lifetime is provided.

First example illustrating the advantages of the invention

In semiconductor production, matching networks are typically operated in a repetitive way in always the same plasma processes or sets of plasma processes. Based on the cumulative recording of activity data, the consumed life can be determined. In addition, by using pattern recognition on the activity data, the different processes can be identified and their respective lengths can be determined. With this information, the lifetime consumed per process cycle, the number of remaining process cycles and the time period until the expected end of life can be calculated.

However, this procedure can easily adapt to new usage profiles of the matching network, e. g. when amended processes or completely new processes are introduced.

The electronic system may be configured to automatically detect such new processes and changes in the usage profile, for example a change in frequency of different known processes. Based on the determined new usage profile, the remaining lifetime can be re-calculated and preventive maintenance can be rescheduled accordingly.

Second example illustrating the advantages of the invention

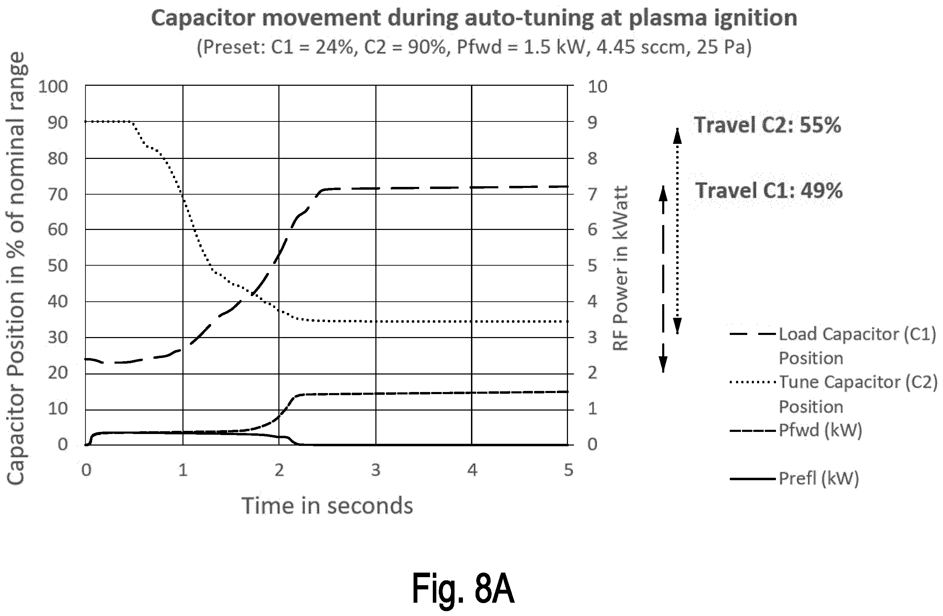

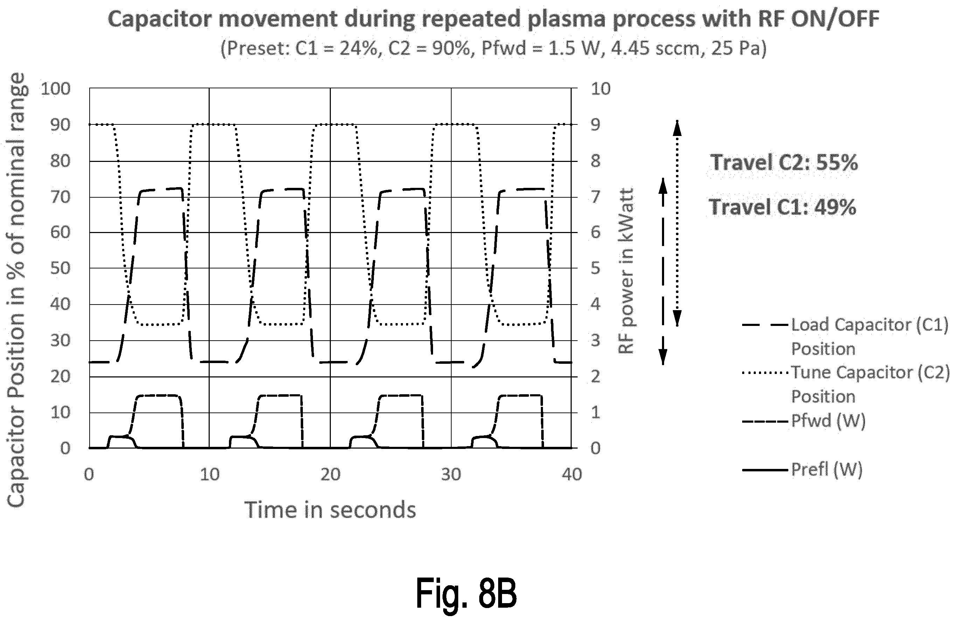

When the user of the electronic system performs the setup for a specific process, he has various degrees of freedom in setting the appropriate starting conditions for reliable ignition of the plasma and fast tuning to a steady-state condition after ignition. Typically, a matching network is operated in automatic mode, i. e. the control of the matching network follows an automated algorithm to find the optimum reactance values for best matching. In an ideal scenario, the reactances move directly from their preset positions to their final values at which the reflected power from the plasma is close to zero as shown in Figures 8A and 8B. However, the ignition of a plasma is a highly dynamic process, and the impedance of the plasma changes while the matching network optimizes the variable reactance values and more and more RF power is fed into the plasma. Therefore, it is well possible that the capacitors may move back and forth several times until an optimum position with minimum reflected power is reached. By optimizing the starting or preset positions of the variable reactance elements before the plasma is ignited, unnecessary mechanical movements of the variable reactance elements can be minimized. In addition, ramping the RF power up in several steps to its target value can facilitate a smooth movement of the variable reactances, therefore advantageously extending the lifetime and consequently also the time before the required next maintenance.

An application of the described invention may be to determine the lifetime of the RF matching network for a specific configuration of a plasma process. For this, the RF matching network can be configured to monitor the variable reactance movements for the plasma process and then to calculate and display the number of process cycles until the expected end of life of the matching network. By repeating this procedure for various starting conditions, and obtaining projected maximum number of process cycles, the user can then select the most favorable starting conditions which allow for maximum lifetime of the matching network and the variable reactance components.

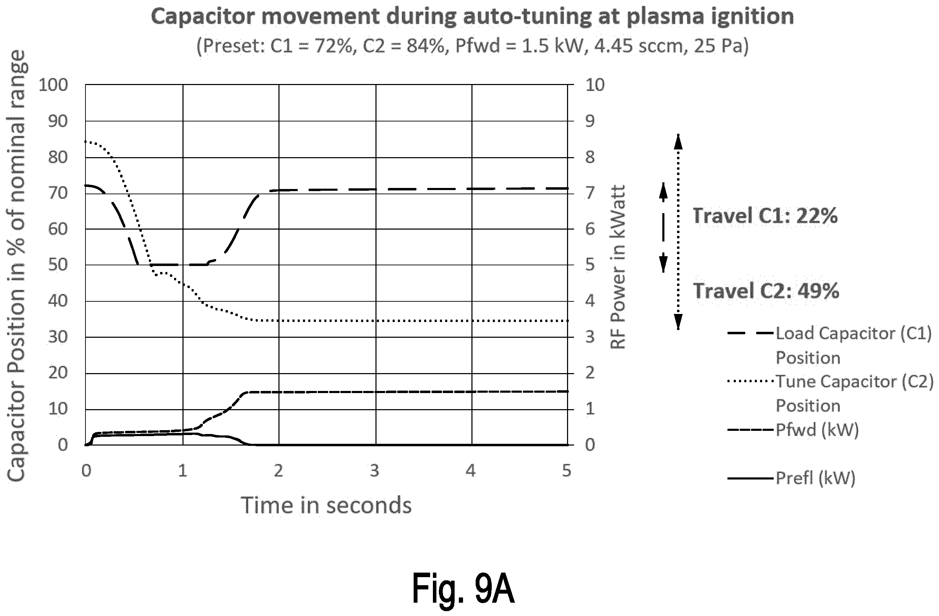

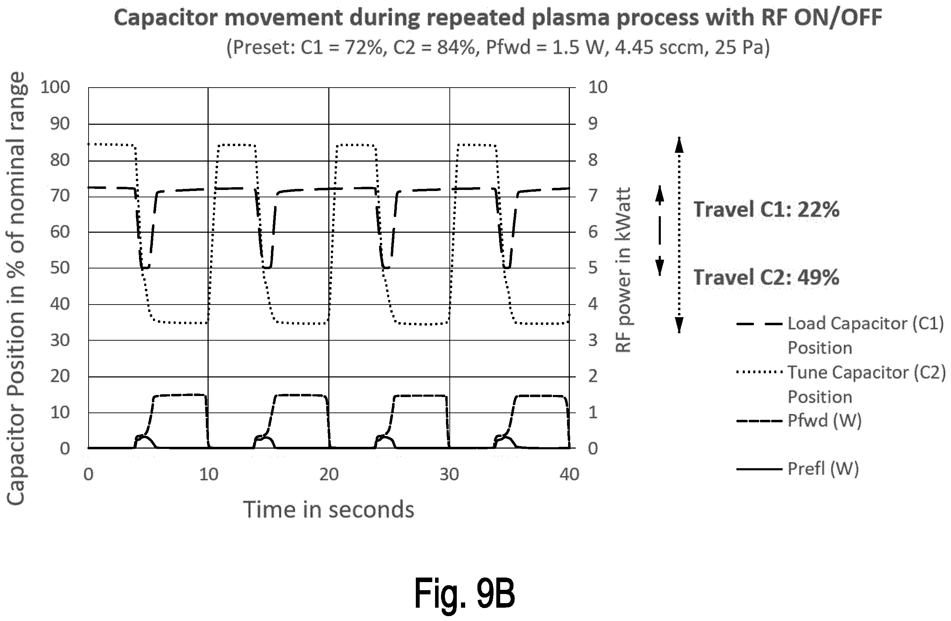

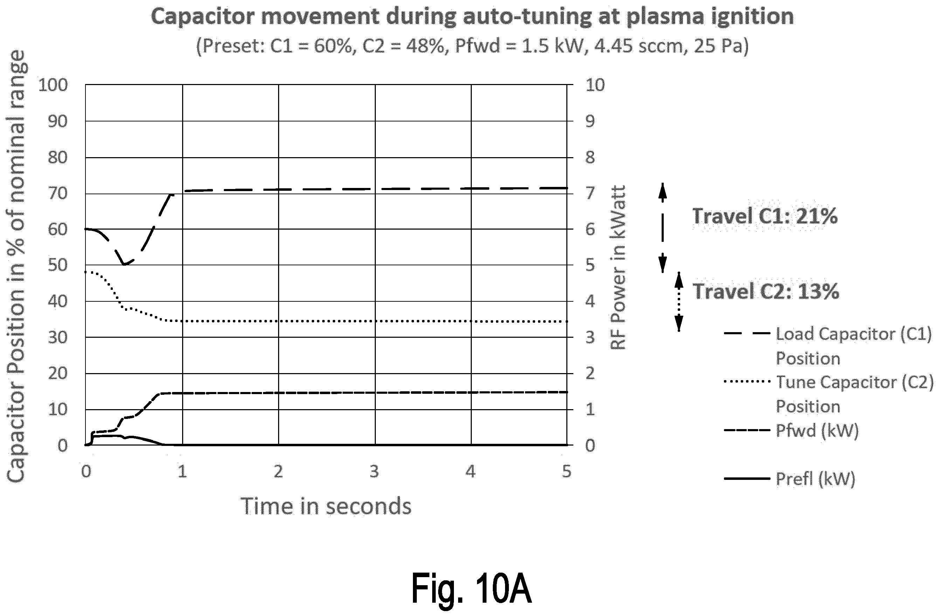

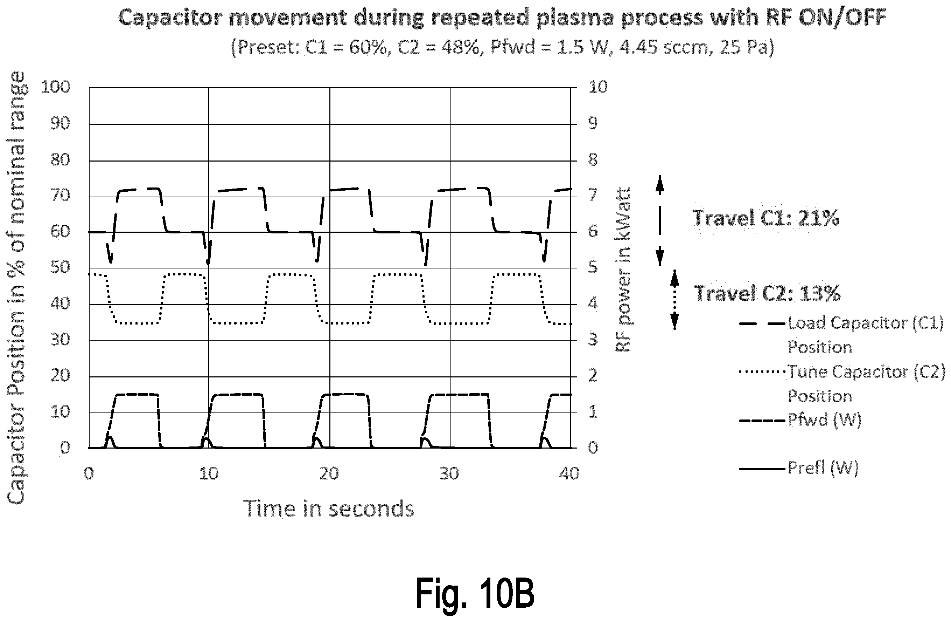

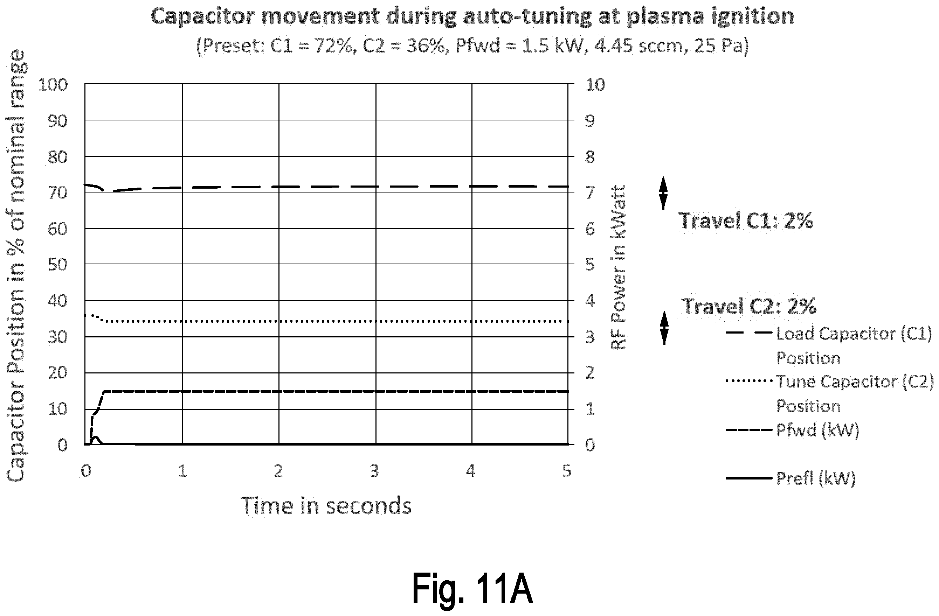

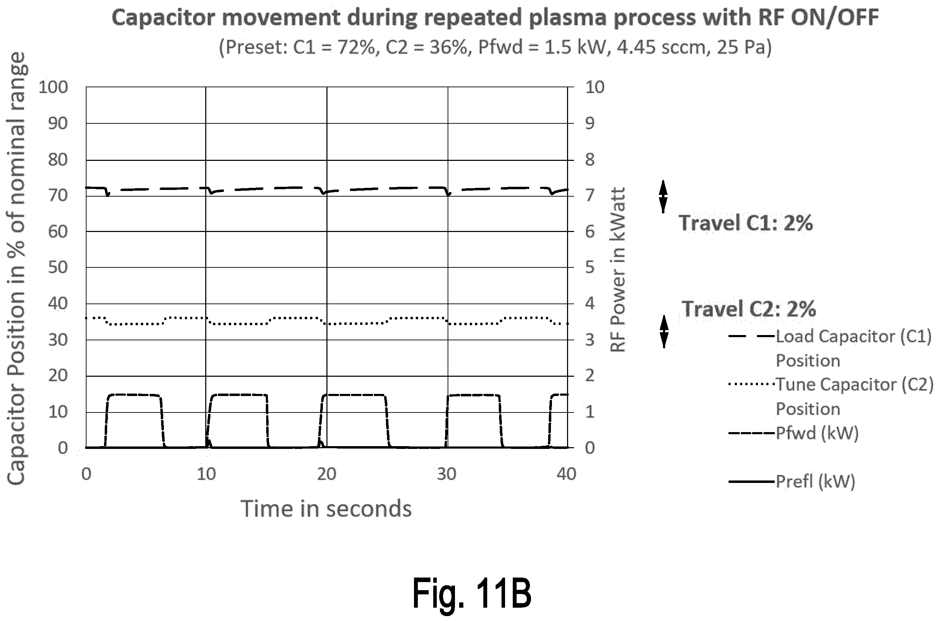

Referring to Figures 8A, 9A, 10A, 11A, examples of the start of a plasma process are shown wherein a plasma is ignited by turning RF power in forward direction "Pfwd" on at time 0 seconds and automatically adjusting the matching network, i. e. the positions of the two variable reactances or capacitors from different preset positions to the tuned positions of minimum reflected power. The load impedance of the fully ignited plasma is defined by RF power, pressure, gas mix and gas flow, and is identical in all four examples. Therefore, the capacitor positions after plasma ignition and tuning, although starting from four different presets, as shown in the examples in Figs. 8A, 9A, 10A, 11A, are the same in all four cases. However, depending on the preset positions of the variable reactances or capacitors, it can take longer or shorter time to reach the steady-state plasma state. If the reflected power "Prefl" is too high when RF power is turned on, the RF generator might limit the output power "Pfwd" to a safe level as can be seen in Figs. 8A and 9A. Only, if the reflected power "Prefl" is reduced during the tuning, the RF power "Pfwd" can be increased to the predefined value. Figs. 8A and 9A show the plasma ignition from two suboptimum preset conditions as both capacitors have to move significantly within their nominal range (20-55%), and the tune time is 1-2 seconds. Fig. 10A shows plasma ignition from more advantageous preset positions, from which the steady state is reached within < 1 second and with capacitor movements of 10-20% of the nominal range. Finally, Fig. 11A shows plasma ignition from optimized preset positions. The capacitors reach the tune position within < 0.2 seconds with small movements of 1-2% of the capacitors' nominal ranges.

Referring to Figs. 8B, 9B, 10B, and 11B, repeated plasma processes with the same conditions as shown in Figs. 8A, 9A, 10A and 11A are shown. The RF power "Pfwd" is turned on for a period of approx. 5 seconds, followed by a periods of 3 seconds with RF power "Pfwd" turned off. Whenever RF is turned on, the matching network automatically adjusts the variable reactances or capacitors from their preset positions until a steady state with minimum reflected power "Prefl" and fully ignited plasma is reached. At the end of each plasma process, in this case after 5 seconds, the RF power "Pfwd" is turned off, and the capacitors are again moved back to their preset positions.

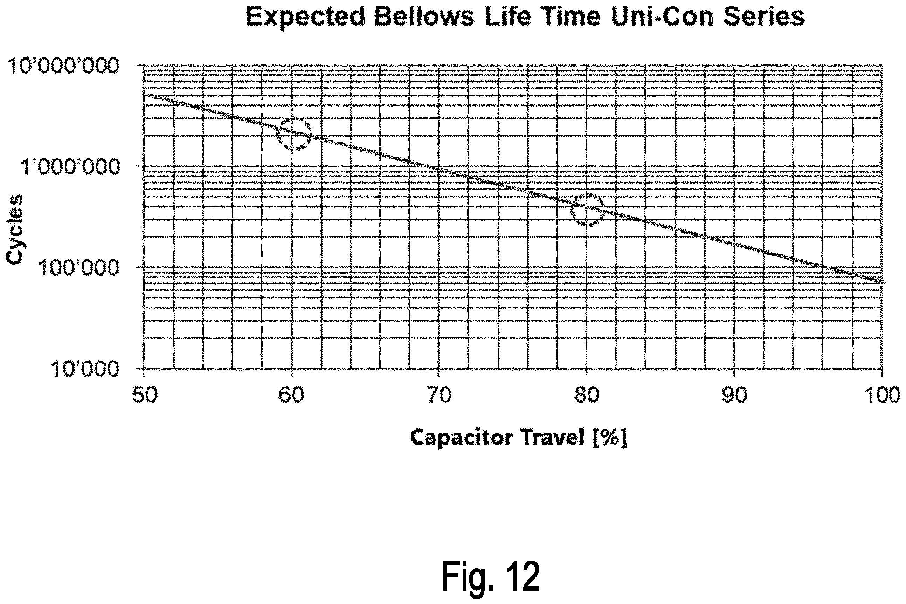

For variable vacuum capacitors, the movement of the capacitors within their nominal range causes compression and expansion of the capacitor bellows. The lifetime of variable vacuum capacitors is strongly dependent on the travel of the capacitors. Referring to Fig. 12, the typical number of movement or tuning cycles until failure of the bellows is shown. For low travel of less than 50% of the nominal range of the capacitor, millions of movements or tuning cycles can be achieved, whereas at high travel, e. g. 80% of the nominal range, only several 100'000 cycles can be obtained before bellows failure.

Similarly, the lead screw and the motors of variable vacuum capacitors or air capacitors will deteriorate with the number of process cycles and the number of rotations per cycle. Therefore, the mechanical movements per process cycle should be minimized.

From the examples in Figs. 8A - 11B, it is obvious that the movements of the capacitors in the matching network can be optimized such that travel of the capacitors and the mechanic stress to their bellows is minimized. At the same time, lead screw and motor movements are minimized as well, and in summary, the overall lifetime of the matching network is increased by optimizing the preset positions of the variable reactances or capacitors.

Third example illustrating the advantages of the invention

Typically, the operating temperature of an electrical, a mechanical, or an electromechanical component has a strong influence on its usable life before wear-out and failure. However, in an RF environment, it is often not possible, or only possible with additional or expensive equipment, to monitor the temperature of components due to interference from RF waves. This is in particular the case for the variable reactances in a matching network. Inner components of vacuum capacitors like the electrodes or the mechanically stressed bellows and lead screws are typically not accessible to temperature sensing devices since they are operated at high currents and voltages, are in vacuum, or are frequently moved. In addition, the current through and the temperature of the reactance components of a matching network vary strongly depending on the operating conditions, in particular they are strongly influenced by the applied RF power "Pfwd" and the plasma impedance. High RF power levels of "Pfwd", e. g. more than 1 kW, or low plasma resistances, e. g. of < 1 Ohm, can easily cause high RF currents > 50 $A_{rms}$ and, therefore, high temperatures. Other power levels and impedances might be significantly less stressful for the components of the matching network.

By using a functional relationship as described by a model of the RF circuit or by using a look-up table connecting the activity information, the RF frequency and the RF power, for each combination of positions of the variable reactance elements, the impedance at the output of the matching network, the electric currents in the various components of the matching network, including the variable reactance elements, can be determined. With a second model of the RF matching network based on thermal modelling or a second look-up table, the temperature of each component of the RF matching network can be determined for steady state conditions. Further refinements of this method may include the temporal variation of the temperature due to the varying impedance and electrical current as well as temporal delays due to slow heat-up and cool-down of the thermal mass of the components.

An application of the described method may be first, to identify the usage profile and the one or more process cycles which the user of the plasma system is employing, e. g. via pattern recognition from the activity data, and then, for each process cycle, to determine the electrical current and the temperature of the components of the matching network. With the activity data and the temperature of the variable reactance elements, the lifetime used per process cycle can be determined, and the remaining lifetime of the matching network be calculated.

Instead of using an ambient temperature, this method is much more accurate and allows to predict the expected lifetime of an RF matching network depending on its actual usage profile with high precision.

**Claims**

1. Method for operating an electronic system comprising a radio frequency, RF, matching network, wherein the RF matching network comprises a plurality of electronic components, wherein at least one of the electronic components is a variable reactance component, wherein the method includes:

    monitoring activity information of the at least one variable reactance component; and
    determining a predicted lifetime from the activity information.

2. Method according to claim 1, wherein the method further includes:

    monitoring at least one operation parameter of the electronic system;
    determining from the at least one operation parameter a temperature of the electronic system; and
    determining a predicted lifetime from the activity information and the determined temperature.

3. Method according to claims 1 or 2, wherein the method further includes:

    monitoring an RF frequency of operation of the electronic system; and
    determining a predicted lifetime from the activity information, and the RF frequency of operation and preferably the determined temperature.

4. Method according to any of claims 1 to 3, wherein if the remaining predicted lifetime is below a predetermined threshold, a warning signal is generated.

5. Method according to any of claims 1 to 4, wherein the predicted lifetime is displayed and/or transmitted to a remote server.

6. Method according to any of claims 1 to 5, wherein the variable reactance component is one of a mechanically adjustable gas capacitor, a mechanically adjustable vacuum capacitor, or a mechanically adjustable inductor.

7. Method according to any of claims 1 to 6, wherein the activity information is a mechanical adjustment of the variable reactance component.

8. Method according to any of claims 1 to 7, wherein the at least one operation parameter comprises an electric current of the electronic system and, in particular, in at least one of the plurality of electronic components.

9. Method according to any of claims 1 to 8, wherein determining from the at least one operation parameter a temperature of the electronic system includes at least one or more of:

    - pre-determine a look-up table providing a connection between the at least one operation parameter and the temperature, and during operation look up the temperature for the respective operation parameter in the look-up table;
    - pre-determine a model of one of the variable reactance component and/or any other electronic component providing a functional relationship between the at least one operation parameter and the temperature and use the functional relationship during operation to determine the temperature;
    - pre-determine a model of the electronic system comprising the at least one variable reactance, further components, and parasitic inductances, capacitances and resistances, providing a functional relationship between the values of the variable reactances and the at least one operation parameter and the temperature, and use the functional relationship during operation to determine the temperature; and
    - train a machine learning algorithm to determine the temperature from the at least one operation parameter and use the trained machine learning algorithm during operation to determine the temperature.

10. Method according to any of claims 1 to 9, wherein the temperature comprises one or more of the temperature of the variable reactance component, the temperature of any other electronic component, and the air temperature within the electronic system.

11. Method according to any of claims 1 to 10, wherein the predicted lifetime includes a predicted number of remaining process cycles, wherein the predicted lifetime is calculated by the predicted number of remaining process cycles and a time between two process cycles.

12. Method according to claim 11, wherein, if the electronic system is operated in two or more different process cycles, the predicted lifetime is determined by a combination of the predicted number of remaining process cycles for each different process cycle and the frequency of occurrence of each of the different process cycles.

13. Method according to claims 11 or 12, wherein the process cycles and the time between two process cycles is determined by pattern recognition.

14. Method according to any of claims 1 to 13, wherein determining the predicted lifetime includes at least one or more of:

- pre-determine a look-up table providing a connection of the activity information and preferably the temperature and/or the RF frequency with the predicted lifetime, and, during operation, look up the predicted lifetime for the respective activity information and preferably the temperature and/or the RF frequency in the look-up table;
- pre-determine a functional relationship between the activity information preferably with the temperature and/or the RF frequency and the predicted lifetime and use the functional relationship during operation to determine the predicted lifetime; and
- train a machine learning algorithm to determine the predicted lifetime from the activity information preferably with the temperature and/or the RF frequency and use the trained machine learning algorithm during operation to determine the predicted lifetime.

15. Electronic system comprising an RF matching network, wherein the RF matching network comprises a plurality of electronic components, wherein at least one of the electronic components is a variable reactance component, wherein the electronic system further comprises a control unit, wherein the control unit is configured to perform the steps of the method according to any of claims 1 to 14.

16. Plasma system comprising a plasma chamber and an electronic system according to any of claims 1 to 15 connected to the plasma chamber.

17. A non-transitory, tangible processor readable storage medium encoded with processor readable instructions, which when executed by a processor performs the steps of the method according to any of claims 1 to 15.

**Amended claims in accordance with Rule 137(2) EPC.**

1. Method for operating an electronic system comprising a radio frequency, RF, matching network, wherein the RF matching network comprises a plurality of electronic components, wherein at least one of the electronic components is a variable reactance component,
**characterized in that**,
the method includes:

monitoring activity information of the at least one variable reactance component;
monitoring at least one operation parameter of the electronic system;
determining from the at least one operation parameter a temperature of the electronic system; and
determining a predicted lifetime from the activity information and the determined temperature.

2. Method according to claims 1, wherein the method further includes:

monitoring an RF frequency of operation of the electronic system; and
determining a predicted lifetime from the activity information, and the RF frequency of operation and the determined temperature.

3. Method according to any of claims 1 to 2, wherein if the remaining predicted lifetime is below a predetermined threshold, a warning signal is generated.

4. Method according to any of claims 1 or 3, wherein the predicted lifetime is displayed and/or transmitted to a remote server.

5. Method according to any of claims 1 to 4, wherein the variable reactance component is one of a mechanically adjustable gas capacitor, a mechanically adjustable vacuum capacitor, or a mechanically adjustable inductor.

6. Method according to any of claims 1 to 5, wherein the activity information is a mechanical adjustment of the variable reactance component.

7. Method according to any of claims 1 to 6, wherein the at least one operation parameter comprises an electric current of the electronic system and, in particular, in at least one of the plurality of electronic components.

8. Method according to any of claims 1 to 7, wherein determining from the at least one operation parameter a temperature of the electronic system includes at least one or more of:

- pre-determine a look-up table providing a connection between the at least one operation parameter and the temperature, and during operation look up the temperature for the respective operation parameter in the look-up table;
- pre-determine a model of one of the variable reactance component and/or any other electronic component providing a functional relationship between the at least one operation parameter and the temperature and use the functional relationship during operation to determine the temperature;
- pre-determine a model of the electronic system comprising the at least one variable reactance, further components, and parasitic inductances, capacitances and resistances, providing a functional relationship between the values of the variable reactances and the at least one operation parameter and the temperature, and use the functional relationship during operation to determine the temperature; and
- train a machine learning algorithm to determine the temperature from the at least one operation parameter and use the trained machine learning algorithm during operation to determine the temperature.

9. Method according to any of claims 1 to 8, wherein the temperature comprises one or more of the temperature of the variable reactance component, the temperature of any other electronic component, and the air temperature within the electronic system.

10. Method according to any of claims 1 to 9, wherein the predicted lifetime includes a predicted number of remaining process cycles, wherein the predicted lifetime is calculated by the predicted number of remaining process cycles and a time between two process cycles.

11. Method according to claim 10, wherein, if the electronic system is operated in two or more different process cycles, the predicted lifetime is determined by a combination of the predicted number of remaining process cycles for each different process cycle and the frequency of occurrence of each of the different process cycles.

12. Method according to claims 9 or 11, wherein the process cycles and the time between two process cycles is determined by pattern recognition.

13. Method according to any of claims 1 to 12, wherein determining the predicted lifetime includes at least one or more of:

 - pre-determine a look-up table providing a connection of the activity information and preferably the temperature and/or the RF frequency with the predicted lifetime, and, during operation, look up the predicted lifetime for the respective activity information and preferably the temperature and/or the RF frequency in the look-up table;
 - pre-determine a functional relationship between the activity information preferably with the temperature and/or the RF frequency and the predicted lifetime and use the functional relationship during operation to determine the predicted lifetime; and
 - train a machine learning algorithm to determine the predicted lifetime from the activity information preferably with the temperature and/or the RF frequency and use the trained machine learning algorithm during operation to determine the predicted lifetime.

14. Electronic system comprising an RF matching network, wherein the RF matching network comprises a plurality of electronic components, wherein at least one of the electronic components is a variable reactance component, wherein the electronic system further comprises a control unit, wherein the control unit is configured to perform the steps of the method according to any of claims 1 to 13.

15. Plasma system comprising a plasma chamber and an electronic system according claim 14 connected to the plasma chamber.

16. A non-transitory, tangible processor readable storage medium encoded with processor readable instructions, which when executed by a processor performs the steps of the method according to any of claims 1 to 13.

10

12    11    14

16

# Fig. 1

S01

Monitoring activity information of the at
least one variable reactance component

S02

Determining a predicted lifetime from the
activity information

# Fig. 2

Monitoring activity information of the at
least one variable reactance component — S01

Monitoring at least one operation
parameter of the electronic system — S03

Determining from the at least one operation
parameter a temperature of the electronic
system — S031

Determining a predicted lifetime from the
activity information and the determined
temperature — S02'

## Fig. 3

RF
Frequency

Activity
Information

Operation
Parameter

Temperature

Lifetime
Predction

Remaining
Lifetime

## Fig. 4

xt

## Fig. 5A

$\Sigma|x(t)|$

## Fig. 5B

Remaining
Lifetime

18

## Fig. 6

| P1 | P2 | P1 | P2 |
|---|---|---|---|
| $t_1$ | $t_2$ | $t_1$ | $t_2$ |

## Fig. 7

Capacitor movement during auto-tuning at plasma ignition
(Preset: C1 = 24%, C2 = 90%, Pfwd = 1.5 kW, 4.45 sccm, 25 Pa)

Travel C2: 55%

Travel C1: 49%

— — — Load Capacitor (C1) Position

· · · · · · · Tune Capacitor (C2) Position

— · — Pfwd (kW)

——— Prefl (kW)

RF Power in kWatt

Capacitor Position in % of nominal range

Time in seconds

Fig. 8A

16

**Capacitor movement during repeated plasma process with RF ON/OFF**
(Preset: C1 = 24%, C2 = 90%, Pfwd = 1.5 W, 4.45 sccm, 25 Pa)

Travel C2: 55%

Travel C1: 49%

— — Load Capacitor (C1) Position

········ Tune Capacitor (C2) Position

----- Pfwd (W)

——— Prefl (W)

Fig. 8B

EP 4 542 620 A1

**Capacitor movement during auto-tuning at plasma ignition**
(Preset: C1 = 72%, C2 = 84%, Pfwd = 1.5 kW, 4.45 sccm, 25 Pa)

Travel C1: 22%

Travel C2: 49%

— — Load Capacitor (C1) Position

·········· Tune Capacitor (C2) Position

----- Pfwd (kW)

——— Prefl (kW)

## Fig. 9A

EP 4 542 620 A1

**Capacitor movement during repeated plasma process with RF ON/OFF**
(Preset: C1 = 72%, C2 = 84%, Pfwd = 1.5 W, 4.45 sccm, 25 Pa)

Travel C1: 22%

Travel C2: 49%

— — Load Capacitor (C1) Position

········· Tune Capacitor (C2) Position

---- Pfwd (W)

—— Prefl (W)

Fig. 9B

**Capacitor movement during auto-tuning at plasma ignition**
(Preset: C1 = 60%, C2 = 48%, Pfwd = 1.5 kW, 4.45 sccm, 25 Pa)

Travel C1: 21%

Travel C2: 13%

– – Load Capacitor (C1) Position

········· Tune Capacitor (C2) Position

- - - - Pfwd (kW)

——— Prefl (kW)

Capacitor Position in % of nominal range

RF Power in kWatt

Time in seconds

Fig. 10A

EP 4 542 620 A1

Capacitor movement during repeated plasma process with RF ON/OFF
(Preset: C1 = 60%, C2 = 48%, Pfwd = 1.5 W, 4.45 sccm, 25 Pa)

Travel C1: 21%

Travel C2: 13%

— — Load Capacitor (C1) Position

········ Tune Capacitor (C2) Position

— — — Pfwd (W)

——— Prefl (W)

Fig. 10B

**Capacitor movement during auto-tuning at plasma ignition**
(Preset: C1 = 72%, C2 = 36%, Pfwd = 1.5 kW, 4.45 sccm, 25 Pa)

Travel C1: 2%

Travel C2: 2%

— — — Load Capacitor (C1) Position

·········· Tune Capacitor (C2) Position

– – – Pfwd (kW)

——— Prefl (kW)

## Fig. 11A

EP 4 542 620 A1

**Capacitor movement during repeated plasma process with RF ON/OFF**
(Preset: C1 = 72%, C2 = 36%, Pfwd = 1.5 kW, 4.45 sccm, 25 Pa)

Travel C1: 2%

Travel C2: 2%

— — —Load Capacitor (C1) Position

·········Tune Capacitor (C2) Position

- - - -Pfwd (kW)

———Prefl (kW)

Fig. 11B

EP 4 542 620 A1

**Expected Bellows Life Time Uni-Con Series**

Cycles vs. Capacitor Travel [%]

Fig. 12

EP 4 542 620 A1

Europäisches
Patentamt

European
Patent Office

Office européen
des brevets

# EUROPEAN SEARCH REPORT

**Application Number**

**EP 23 20 3957**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/204145 A1 (ADVANCED ENERGY IND INC [US]) 29 September 2022 (2022-09-29) | 1,3,6,7, 11-17 | INV. H01J37/32 |
| Y | * figures 1, 2, 3, 5, 8 * <br> * claims 10-15 * <br> * paragraph [0006] – paragraph [0007] * <br> * paragraph [0028] – paragraph [0030] * <br> * paragraph [0033] – paragraph [0042] * | 9 | H03H7/40 |
| X | US 2009/249128 A1 (HECKMAN RANDY L [US] ET AL) 1 October 2009 (2009-10-01) | 1-8,10, 12 | |
| Y | * figures 1-4 * <br> * paragraph [0005] – paragraph [0054] * | 9 | |
| A | US 2020/286720 A1 (VAN GREUNEN CORNELUIS ERASMUS [US] ET AL) 10 September 2020 (2020-09-10) <br> * figures 1,-3, 6, 9 * <br> * paragraph [0017] – paragraph [0045] * <br> * paragraph [0050] – paragraph [0063] * | 1-17 | |
| A | KR 2015 0073260 A (WONIK IPS CO LTD [KR]) 1 July 2015 (2015-07-01) <br> * claim 1 * <br> * the whole document * | 1-17 | TECHNICAL FIELDS SEARCHED (IPC) <br><br> H01J <br> H03H |

The present search report has been drawn up for all claims

| Place of search | Date of completion of the search | Examiner |
|---|---|---|
| The Hague | 11 March 2024 | Hochstrasser, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 542 620 A1**

## ANNEX TO THE EUROPEAN SEARCH REPORT
## ON EUROPEAN PATENT APPLICATION NO.

EP 23 20 3957

11-03-2024

| Patent document cited in search report | | Publication date | Patent family member(s) | | Publication date |
|---|---|---|---|---|---|
| WO 2022204145 | A1 | 29-09-2022 | EP | 4314965 A1 | 07-02-2024 |
| | | | KR | 20230162044 A | 28-11-2023 |
| | | | TW | 202248667 A | 16-12-2022 |
| | | | US | 2022334197 A1 | 20-10-2022 |
| | | | WO | 2022204145 A1 | 29-09-2022 |
| US 2009249128 | A1 | 01-10-2009 | TW | 200947582 A | 16-11-2009 |
| | | | US | 2009249128 A1 | 01-10-2009 |
| | | | WO | 2009146003 A1 | 03-12-2009 |
| US 2020286720 | A1 | 10-09-2020 | CN | 113767570 A | 07-12-2021 |
| | | | EP | 3935734 A1 | 12-01-2022 |
| | | | JP | 2022523807 A | 26-04-2022 |
| | | | KR | 20210132191 A | 03-11-2021 |
| | | | PL | 3935734 T3 | 29-01-2024 |
| | | | TW | 202103211 A | 16-01-2021 |
| | | | US | 2020286720 A1 | 10-09-2020 |
| | | | US | 2021111009 A1 | 15-04-2021 |
| | | | WO | 2020180848 A1 | 10-09-2020 |
| KR 20150073260 | A | 01-07-2015 | NONE | | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20220334197 A1